# EUROPEAN PATENT APPLICATION

(11) **EP 1 445 340 A2**
(43) Date of publication of application: **11.08.2004**
(21) Application number: 02782036.4
(22) Date of filing: 22.10.2002
(51) Int. Cl.: C21D 8/06, C22F 1/18, D07B 1/06

(54) **METHOD FOR PRODUCING MONOCRYSTALLINE METALLIC WIRE**

(30) Priority: 25.10.2001 RU 2001128838
(71) Applicant: MARKOV, Gennadij A., Novosibirsk, 630055 (RU)
(72) Inventor: MARKOV, Gennadij A., Novosibirsk, 630055 (RU)
(74) Representative: HOFFMANN - EITLE
(86) International application number: PCT/RU2002/000461
(87) International publication number: WO 2003/035915

(57) **Abstract**

The invention relates to metalware of commercial purpose, more specifically, to a metal wire, and concerns a method for producing a fine single-crystal metal wire with a diameter of from 0.01 µm to 5 µm. The method comprises subjecting a wire to uniform plastic deformation to a degree of over 98% by twisting two wires to spiral with an angle of inclination of spiral turns of 20-58 degrees to the spiral longitudinal axis at a predetermined twisting speed in time with a heat treatment, and cleaning the resultant wire from polycrystalline metal residues. The method further comprises subjecting a wire to shear plastic deformation to a degree of over 98% by twisting one wire around the longitudinal axis of the wire in the yield condition of the metal until filamentary monocrystals are formed. In some cases, the metal wire deformation can be carried out at a temperature of (-200)-400°C. All of the processing parameters are set by experiment. Single-crystal nature of the wire is confirmed by x-ray phase analysis. If a single-crystal wire with polycrystalline residues is unacceptable, single-crystal filaments are cleaned by a chemical method.

## Description

### Field of the Invention

The invention relates to metalware of commercial purpose, more specifically, to a metal wire, and concerns a method for producing a fine single-crystal metal wire with diameters of from 0.01 µm to 5 µm.

A wire can be produced of a diameter from few micrometers and is classified, according to size, in the categories: (a) extra-fine wire with diameter less than 0.1 mm; (b) finer wire with diameter from 0.10 to 0.4 mm; (c) fine wire with diameter from 0.4 to 1.6 mm; (d) middle-size wire with diameter from 1.6 to 6.0 mm; (e) thick wire with diameter from 6.0 to 8.0 mm; and (f) extra-thick wire with diameter more than 8.0 mm.

A cold-drawn wire production process generally comprises: removing scale from a surface of a rod (a metal workpiece obtained by rolling an ingot), drawing and heat treating (if required), galvanizing, tinning, etc. The rod prepared to drawing is drawn to size at drawing benches. Depending on a target diameter, a wire can be drawn at one- or multipass drawing benches. Middle and fine drawing is performed at multipass drawing machines. A wire with a diameter of up to 0.8 mm is drawn through steel drawplates, while a finer wire is drawn through diamond dies (Technical Encyclopedia, vol.17, Moscow, OGIZ RSFSR, 1932).

### Background of the Invention

A number of inventions relate to improvements in apparatuses for multipass drawing of wire or traction mechanisms of drawing machines.

An apparatus for multipass drawing of a wire, taught in SU Inventor's Certificate 1 759 496, IPC⁵ B 21 C 1/14, published in Bulletin of Inventions No.33, 1992, comprises a number of drawing dies and drive spindles on which draw sheaves are mounted. To improve operational reliability by the ability to adjust the sheave diameters, landing surfaces are made conic, and each sheave comprises a mechanism for fixation on the spindle and a longitudinal cut on the external surface. An apparatus for drawing a wire with heating in a heat-transfer liquid (RU Patent 2 116 851, IPC⁶ B 21 C 1/08, published in Bulletin of Inventions No.22, 1998) comprises a bath, such as an open cylinder cavity, the front end wall of the bath having a slit recess coaxial with the vertical axis of the die, the bath being hinged on a support and having, in the upper part, a cover with guide brackets arranged therein, wherein the bath hinge is eccentric with respect to the bath's center of gravity at a distance equal to 0.05-0.3 distance from the bath's center of gravity to its front end; a die at the front end of the bath is fastened by a bracket, and a height stop is provided on the support in the back end region of the bath.

A direct-flow drawing bench (RU Patent 2 144 854, IPC⁷ B 21 C 1/08, published in Bulletin of Inventions No.3, 2000) comprises a series of dies and respective, parallel to each other, double-seat drive spindles of traction drums having working surfaces in the shape of truncated cones, each of the dies being arranged in the larger base plane of the conic working surface of a respective traction drum, and the working surfaces of even and odd (in the drawing direction order) traction drums being made with mutually opposite cones.

A continuous wire drawing installation (JP 70 04618 B4, IPC⁶ B 21 C 1/12, published on January 25, 1995) comprises a winder for winding a wire material; a lever rotating in response to variation in the tension force of the wire material on a pin in the upper part of the winder; a roller to distribute the wire material W, the roller being rotationally mounted at the front end of the lever; a die for drawing the wire material unwound by said roller from the winder. The installation comprises a sensor to determine a deviation in the lever position with respect to the direction of its rotation, the deviation being caused by a fluctuation in the wire processing speed in the die, and a processor for calculating, responsive to the sensor readings, a correction value for correcting the drawing speed.

A traction mechanism of a sliding drawing machine (RU Patent 1 759 495, IPC⁵ B21C 1/14, published in Bulletin of Inventions No.33, 1992) comprises a drive spindle having a tire with flanges set on the spindle; solids of revolution arranged around the tire circumference, and a ring located on the solids of revolution between the flanges, wherein in order to improve operational reliability the ring is made by several segments adapted to form therebetween a total clearance smaller than the diameter of the solids of revolution, and the ring has a groove on the external surface and is connected to the flanges via a groove-extension connection with gaps in radial and axial directions. An extra-fine wire (microwire) with diameter 0.5 µm ensures a considerably reduced weight and dimensions of elements made from the microwire, and reduces mechanical, thermal and electric inertia thereof. The microwire is produced by casting in glass insulation. Prior art documents describe the microwire casting technique. The documents teach how to form a capillary and fill it with a liquid metal; describe a structure and separate units of microwire casting installations; micro-furnaces; glass and metal supply mechanisms; reception mechanism; control systems, etc. (Micrometallurgy and Microtechnology, Leningrad, 1959).

A method is known for producing a cast microwire from metal alloys in glass insulation (SU Inventor's Certificate 237 941, IPC H01B 13/06, published in Bulletin of Inventions No.9, 1969), comprising flesh smelting of a weighted metal charge by high-frequency currents, the metal charge being placed in a glass pipe from which a ready microwire is drawn by a rotary bobbin in the form of a cooled thin glass capillary with a continuous metal filling, whose linear resistance is monitored and adjusted by automatic variations in the microwire reception speed and the pressure above the metal drop in the microfurnace. To improve the microwire quality, the end of the glass pipe is formed in a head-rounding whose shape resembles the metal drop shape; the pipe is then treated by a degreasing compound, and the metal charge is heat-treated in vacuum. The prior art also teaches a glass composition depending on the linear resistance of the resultant cast microwire.

SU Inventor's Certificate 240 797, IPC H01B 13/06, published in Bulletin of Inventions No.13, 1969, describes an installation for casting a microwire in glass insulation. The installation comprises a high-frequency generator for melting metal, mechanisms for supplying glass and metal charge, receiving the microwire, and breaking a wire strand. Tests of the microwire structure were conducted. They have shown that a copper microwire strand with diameter less than 14 µm is single crystal in the cross-section. With large diameters, the structure will be polycrystalline one with large grains (FTT, 1960, issue 12, p.3048-49).

A method was developed for producing single-crystal bismuth filaments of cylindrical shape with a diameter of from 5 to 1 µm and a length of up to several hundreds meters (Instruments and Experiment Technique, 1976, 3, p.256-257).

All of the conventional methods suffer problems with production of a cast microwire from low-melting-point metals and alloys, caused by the melting point of glass for making capillaries, claddings for the microwire, as well as with production of a wire, which is polycrystalline in the cross-section.

The object of the present invention is to provide a method for producing a metal wire, such as fine filaments with a diameter of 0.1-5 µm, which maintains its single-crystal nature along the entire length of the wire, as well as producing a wire from refractory metals, such as tungsten, molybdenum, etc.

The object of the invention is accomplished by subjecting a wire to uniform plastic deformation to a degree of over 98% by twisting two wires to spiral with an angle of inclination of spiral turns of 20-58 degrees to the spiral longitudinal axis at a predetermined twisting speed in time with heat treatment, and cleaning the resultant wire from polycrystalline metal residues, if required.

To attain the object of the invention, each of the wires is pre-twisted around its longitudinal axis before the deformation.

The object of the invention is also attained by subjecting a wire to shear plastic deformation to a degree of over 98% by twisting one wire to spiral around the longitudinal axis of the wire in the yield condition of the metal until filamentary single crystals are formed.

To attain the object of the invention, the metal wire is subjected to deformation at a temperature of (-200)-400°C.

To attain the object of the invention, the wire is cleaned from polycrystalline residues by a chemical method, if required.

The present method differentiates from conventional methods for producing a metal wire in that single-crystal filaments are formed by twisting two wires around their common axis or by twisting one wire around its longitudinal axis in the yield condition of the metal, this preventing breakage of the metal and enabling the production of a single-crystal wire of infinite length.

No prior arts teaching a similar method for producing a single-crystal metal wire have been found.

The degree of deformation, angle of inclination of spiral turns to the spiral longitudinal axis, and twisting speed were found experimentally for each metal. It has been found that the degree of deformation is dictated by the twisting speed: depending on the twisting speed either a single-crystal wire or a wire with a large number of dislocations is produced; the single-crystal nature was tested along the entire length of the wire by x-ray phase analysis.

### SUMMARY OF THE INVENTION

When a metal cylindrical sample is stretched, a neck, i.e. a local reduction in the sample lateral dimension, is generally formed before the sample rupture (breakage); this reduces the stretching force required for deformation. The ratio between the greatest stretching force value and the sample cross-sectional area before loading is referred to as a conventional ultimate strength. A true ultimate strength is the ratio between the stretching force value directly before the breakage and the smallest cross-sectional area at the neck. At uniaxial stretching, the conventional ultimate strength value is less than the true one. In brittle materials, the local reduction in lateral dimensions before breakage is negligible, thus the conventional ultimate strength and true ultimate strength values differ little. When a thin-wall tubular sample is twisted, shear ultimate strength is generally defined as the greatest tangential stress preceding the sample rupture.

Scientific and reference literature describes standard methods for testing predictive breakage, compression and shift deformation characteristics of a metal by twisting a thin-wall tubular sample. The standard methods are unacceptable for testing predictive breakage characteristics of a wire, and the use can be made only of their terminology and classification concepts.

In testing a wire for stretching, deformation of the wire increases with load and when the load exceeds the ultimate strength, breakage occurs.

When a wire is twisted by a method in accordance with the invention, i.e. by twisting two wires to spiral with an angle of inclination of spiral turns to the spiral longitudinal axis of 20-58 degrees at a predetermined twisting speed in time, as the load increases, the wire deformation also increases up to the degree of 98%. A metal wire is generally a polycrystalline formation, i.e. an aggregate of small monocrystals with different orientation. Properties of the polycrystals are provided by both single-crystal grains per se, their average dimension (from 1-2x10⁻⁶ to several mm), orientation, and grain boundaries. Generally, a polycrystal has a great number of dislocations and point imperfections (vacancies, impurity and interstitial atoms). Diffusion of the imperfections along the grain boundaries differs from the diffusion through crystal grains. Grain boundaries can act as vacancy "sources" and "sinks", impurity "traps", and dislocation attachment places.

When a wire is twisted with the degree of deformation of 98%, crystals are destroyed and a great quantity of heat is released, this transforming the metal into the yield condition, and no breakage of the wire occurs. At further twisting of the wire under an increased load, the degree of deformation increases to 98% and higher. The absence of wire breakage is explained by the fact that point imperfections in wire crystals and crystal boundaries disappear, and filamentary monocrystals are formed in the wire material. To accelerate the plastic deformation process, each of the wires can be pre-twisted around its longitudinal axis.

The same mechanism of single-crystal wire formation is observed when one wire is twisted around its longitudinal axis at a predetermined speed. It has been found that to transform a wire into the state of filamentary monocrystals in the yield condition of the metal, heating is required, which can be performed by electric current or other conventional methods. However, the filamentary monocrystals can be also obtained due to natural heating of the wire when it is subjected to deformation by twisting at a predetermined wire rotation speed.

It has been also found that to produce single-crystal filaments from such metals as nickel, iron, copper, aluminum, indium, the process of twisting should be carried out with cooling. By way of example, cooling is required to (-30)-(-70)°C for iron wire, (-70)-(-100)°C for copper wire, (-170)-(200)°C for indium wire.

It has been also found that steel single-crystal filaments can be produced both with heating or cooling. By way of example, a wire from carbon steel, nitrated steel and other hard-alloy steels can be made both at room temperature and when heated.

The lower temperature limit for each particular metal is defined by the beginning of splitting in the wire material under deformation.

The upper temperature limit for each particular metal is defined by the beginning of termination of filamentary single crystal formation.

After transforming the polycrystalline base into a single-crystal one by twisting, the polycrystalline phase residue in the wire is 10-20% of the total wire volume. If the wire of such quality is unacceptable, the polycrystalline residue can be removed by electrochemical etching in alkaline or metal salt solutions.

### Description of Embodiments

Example 1. To produce a tungsten wire 2 µm in diameter with a single-crystal structure, a wire with diameter 40 µm drawn through dies was used. Two wires of the same length were taken. Ends of the wires were clamped at one side on a movable carriage, and attached, at the other side, to an electric motor shaft whose revolutions were controlled within a wide range. The wire twisting speed was set so that variation of the angle of inclination of spiral turns to the longitudinal axis was 0.05 degree/min and the final angle of inclination was 86 degrees. After twisting, the wire formed a set of thin single-crystal filaments 2 µm in diameter, which were uniformly arranged across the section in the polycrystalline phase. The wire was cleaned from the polycrystalline base by electrochemical etching in an alkaline solution, and two strands of metal filaments were obtained.

Example 2. To produce a single-crystal copper wire 2-3 µm in diameter, a copper wire rod 0.7 mm in diameter was provided and twisted around its longitudinal axis with a speed of 4 to 10 revolutions per minute for a wire having a total length of 1 m. The wire twisting process was carried out under the plastic deformation conditions until single-crystal fibers formed in the wire volume were at the angle of 76 degrees to the wire longitudinal axis. Torque force acting on the wire was set by the electric motor through variation in the feeding voltage. The voltage was applied to the motor stepwise at 5 V steps. When the voltage at the motor was 55 V, plastic deformation of the wire started and simultaneously the wire hardness and, consequently, its elastic forces increased, the plastic deformation continued until the motor voltage reached 65 V. At 65 V, the copper ultimate strength was reached, and filamentary single crystals started to form as the result of shear deformation of the wire along the entire length. For this reason the wire lost its elastic properties for a long time until a sufficient number of filamentary single crystals was formed throughout the entire volume, the filamentary single crystals were then twisted around the wire longitudinal axis to form a strand of thin filaments, and when a tight twist was attained, the copper strand regained elastic properties which stopped rotation of the motor.

A table below illustrates the motor operation time versus the voltage applied to the motor, wherein termination of the motor operation is explained by equilibrium established between the wire elastic forces and the motor operating torque.

| | | | | | |
|---|---|---|---|---|---|
| Voltage at motor, V | 45 | 50 | 55 | 60 | 65 |
| Motor operation time, min | 0.25 | 3 | 14 | 30 | 514 |

Example 3. To produce a single-crystal steel wire 3-4 µm in diameter, a carbon steel wire with a diameter of 0.4 mm was taken and twisted around its longitudinal axis at a speed of 4-10 revolutions per minute, the total length of the wire being 1 m. The wire twisting process was carried out under plastic deformation conditions until the angle of 56 degrees was formed between single-crystal filaments formed in the wire volume and the wire longitudinal axis. This example describes behavior of a carbon steel wire at shear plastic deformation in the conditions of its twisting around the longitudinal axis at room temperature. The required torque force was set at the wire by an electric motor through variation in the feeding voltage. The voltage was applied to the motor stepwise at 5 V steps.

The table below illustrates the motor operation time from application of voltage to the motor stoppage caused by equilibrium established between wire elastic forces and the motor operating torque.

| | | | | | | | | | |
|---|---|---|---|---|---|---|---|---|---|
| Voltage at motor, V | 40 | 45 | 50 | 55 | 60 | 65 | 70 | 75 | 80 |
| Motor operation time, min | 0.41 | 0.63 | 0 | 0.93 | 0.73 | 0 | 1.88 | 36 | 135 |

As follows from the table, during applying a voltage of from 40 to 65 V to the motor, a complicated process of variation in the elastic force distribution takes place in the wire. During this period the wire was twisted to a cylinder spiral 30 mm in diameter with 46 mm pitch between the turns. At 70 V, elastic forces started to be broken, consequently, the diameter and pitch of the cylinder steel spiral turns reduced. At 75 V at the motor, the plastic deformation process was over, the resultant wire became straight and started twisting around its longitudinal axis. At 80 V at the motor, the process of forming filamentary single crystals took place. After 135 minutes of twisting the wire, the process was terminated; the angle of inclination of single-crystal filaments to the longitudinal axis was 54 degrees. Therefore, the carbon steel wire turned into a strand of twisted filamentary crystals or thin single-crystal wires with a diameter of from 3 to 4 µm. To confirm it, the strand was layer etched in spared fashion step-by-step from the strand surface to the center. The single-crystal nature of the filaments was confirmed by x-ray phase analysis. Single-crystal tungsten and molybdenum wires were obtained similarly to the steel wire by twisting a single wire.

Example 3. To produce a single-crystal molybdenum wire 1.3 µm in diameter, a molybdenum wire with diameter of 50 µm was used. Two wires were twisted to spiral with the speed of variation of the angle between the axis of wire turns and the spiral longitudinal axis of 0.35-0.4 degree/min.

Example 4. To produce a single-crystal iron wire 1.5 µm in diameter, a wire with diameter of 100 µm was used. Two wires were fastened to an electric motor as in Example 1. The twisting process was carried out with the wire cooled to a temperature of -70°C at the 0.1°/min speed of variation of the angle between the axis of wire turns and the spiral longitudinal axis. Cleaning and x-ray phase analysis were performed as in Examples 1 and 2. The length of the resultant wire was from few centimeters to tens of meters, and a wire of any length could be produced.

### Industrial Applicability

The method was used to produce ultrastrong single-crystal metal filaments of infinite length from tungsten, molybdenum, copper, iron, steel, nickel, nichrome, aluminum, indium and other metals. The metal filaments were tested for breakage and tolerated a load 3-4 times greater than the original wire. They are suitable for fabricating high-temperature superconductors and for reinforcing articles of metals and plastics.

## Claims

1. A method for producing a single-crystal metal wire, comprising: subjecting a wire to uniform plastic deformation to a degree of over 98% by twisting two wires to spiral with an angle of inclination of spiral turns to the spiral longitudinal axis of 20-58 degrees at a predetermined twisting speed in time with a heat treatment, and cleaning the resultant wire from polycrystalline metal residues.

2. The method of claim 1, wherein each of the wires is pre-twisted around its longitudinal axis before the deformation.

3. A method for producing a single-crystal metal wire, comprising: subjecting a wire to shear plastic deformation to a degree of over 98% by twisting one wire around the longitudinal axis of the wire in the yield condition of the metal until filamentary monocrystals are formed, and cleaning the resultant wire from polycrystalline metal residues.

4. The method of claim 1 or 3, wherein the metal wire is subjected to deformation at a temperature of (-200)-400°C.

5. The method of claim 1 or 3, wherein the single-crystal wire is cleaned from polycrystalline metal residues by a chemical method.
